# EUROPÄISCHE PATENTANMELDUNG

(11) **EP 1 615 272 A2**
(43) Veröffentlichungstag der Anmeldung: **11.01.2006**
(21) Anmeldenummer: 05014509.3
(22) Anmeldetag: 05.07.2005
(51) Int. Cl.: H01L 31/048

(54) **Verfahren und Vorrichtung zum Zusammenbauen eines Solarzellenmoduls**

(30) Priorität: 06.07.2004 DE 102004032604
(71) Anmelder: Lenhardt Maschinenbau GmbH, D-75242 Neuhausen-Hamberg (DE)
(72) Erfinder: Schuler, Peter, 75233 Tiefenbronn (DE)
(74) Vertreter: Twelmeier, Ulrich

(57) **Zusammenfassung**

Beschrieben wird ein Verfahren zum Zusammenbauen eines Solarzellenmoduls (12), bestehend aus zwei zueinander parallelen, an ihrem Rand dicht miteinander verklebten Platten (9, 10), von denen wenigstens eine lichtdurchlässig ist, zwischen welchen mehrere Solarzellen (27) angeordnet sind und sich ein von Luft verschiedenes Gas befindet, durch
(a) Auftragen einer Klebe- und Dichtmasse auf den Rand von wenigstens einer der beiden Platten (9, 10),
(b) Anbringen der Solarzellen (27) an wenigstens einer der Platten (9, 10),
(c) Wegbiegen wenigstens eines Abschnittes einer (9) der beiden Platten von der gegenüberliegenden Platte (10), wobei der Abschnitt, der weggebogen wird, einen Randbereich der Platte (9) einschließt,
(d) Anordnen der beiden Platten (9, 10) einander gegenüberliegend,
(e) Annähern der beiden Platten (9, 10) aneinander, so dass sie mit Ausnahme des weggebogenen Randbereiches miteinander verkleben,
(f) Abdichten eines den Zwischenraum zwischen den Platten (9, 10) einschließenden Raumes am oder in der Umgebung des noch offenen Randbereiches des Solarzellenmoduls (12),
(g) Abpumpen von Gas aus dem Raum unter Absenkung des Drucks in dem Raum,
(h) Rückgängigmachen der Biegung der einen Platte (9) und Verkleben der beiden Platten (9, 10) miteinander auch in dem Randbereich, in welchem sie bisher noch nicht miteinander verklebt waren, unter Aufrechterhaltung eines Unterdrucks in dem Raum.

## Beschreibung

Die vorliegende Erfindung befasst sich mit einem Verfahren und einer Vorrichtung zum Zusammenbauen eines Solarzellenmoduls, welcher Licht in elektrischen Strom wandelt, In einem Solarzellenmodul werden mehrere Solarzellen, zumeist dünne Siliziumscheiben, auf einer als Träger dienenden Platte angeordnet und durch elektrische Leiterbahnen miteinander verbunden, welche zwischen den Solarzellen und der sie tragenden Platte verlaufen. Um die der Sonne zugewandte Vorderseite der Solarzellen vor Witterungseinflüssen zu schützen, ist es bekannt, die Vorderseite der Solarzellen durch eine lichtdurchlässige Platte abzudecken. In der vorliegenden Erfindung geht es darum, Solarzellemodule herzustellen, in welchen mehrere Solarzellen zwischen zwei zueinander parallelen Platten angeordnet sind, von denen wenigstens eine, nämlich die der Sonne zugewandte Seite, lichtdurchlässig ist, wobei sich zwischen den beiden Platten ein von Luft verschiedenes Gas befindet, welches dadurch in dem Zwischenraum zwischen den beiden Platten gehalten wird, dass diese am Rand dicht miteinander verklebt sind. Derartige Solarzellenmodule versprechen einen erhöhten Wirkungsgrad. Um sie wirtschaftlich herstellen zu können, lehrt die vorliegende Erfindung das Verfahren mit den im Patentanspruch 1 angegeben Merkmalen. Eine zur Verwendung in diesem Verfahren besonders geeignete Vorrichtung ist Gegenstand des Patentanspruchs 21. Vorteilhafte Weiterbildungen der Erfindung sind Gegenstand der Unteransprüche.

Das erfindungsgemäße Verfahren zum Zusammenbauen eines Solarzellenmoduls, bestehend aus zwei zueinander parallelen, an ihrem Rand dicht miteinander verklebten Platten, von denen wenigstens eine lichtdurchlässig ist, zwischen welchen mehrere Solarzellen angeordnet sind und zwischen welchen sich ein von Luft verschiedenes Gas befindet, kennzeichnet sich durch die folgenden Schritte:
(a) Auftragen einer Klebe- und Dichtmasse auf den Rand von wenigstens einer der beiden Platten,
(b) Anbringen der Solarzellen an wenigstens einer der Platten,
(c) Wegbiegen wenigstens eines Abschnittes einer der beiden Platten von der gegenüberliegenden Platte, wobei der Abschnitt, der weggebogen wird, einen Randbereich der Platte einschließt,
(d) Anordnen der beiden Platten einander gegenüberliegend,
(e) Annähern der beiden Platten aneinander, so dass sie mit Ausnahme des weggebogenen Randbereiches miteinander verkleben,
(f) Abdichten eines den Zwischenraum zwischen den Platten einschließenden Raumes am oder in der Umgebung des noch offenen Randbereiches des Solarzellenmoduls,
(g) Abpumpen von Gas aus dem Raum unter Absenkung des Drucks in dem Raum,
(h) Rückgängigmachen der Biegung der einen Platte und Verkleben der beiden Platten miteinander auch in dem Randbereich, in welchem sie bisher noch nicht miteinander verklebt waren, unter Aufrechterhaltung eines Unterdrucks in dem Raum.

In diesem Verfahren kann die Reihenfolge der Schritte (a) und (b) und die Reihenfolge der Schritte (c) und (d) jeweils untereinander vertauscht werden.

Das erfindungsgemäße Verfahren hat wesentliche Vorteile:
◆ Das Verfahren ist wirtschaftlich durchführbar.
◆ Durch das Absenken des Drucks im Solarzellenmodul unter den normalen Luftdruck in der umgebenden Atmosphäre läßt sich der Wirkungsgrad des Solarzellenmoduls erhöhen.
◆ Der Solarzellenmodul ist schon weitgehend geschlossen, wenn man die Druckabsenkung durchführt, weil die beiden Platten des Solarzellenmoduls an ihrem Rand bereits miteinander verklebt sind, mit Ausnahme des wenigstens einen Abschnittes, an welchem eine der beiden Platten von der anderen Platte weggebogen ist. Deshalb kann sich die Druckabsenkung von vorneherein auf den Zwischenraum zwischen den beiden Platten konzentrieren, was günstig für eine niedrige Taktzeit des Verfahrens und für einen geringen Verbrauch des von Luft verschiedenen Gases ist.
◆ Eine Pumpe, welche man zum Absenken des Drucks im Zwischenraum zwischen den beiden Platten des Solarzellenmoduls benötigt, kann zugleich dafür eingesetzt werden, den erwünschten Gasaustausch indem Solarzellenmodul herbeizuführen, in dem zunächst Luft abgepumpt und die abgepumpte Luft ganz oder teilweise durch ein von Luft verschiedenes Gas ersetzt wird.

Ein nur teilweises Ersetzen kommt dann in Betracht, wenn im ersten Schritt die Luft weitgehend aus dem Zwischenraum zwischen den Platten des Solarzellenmoduls evakuiert wurde. Dann genügt es, das von Luft verschiedene Gas bis zum Erreichen eines gewünschten Unterdruckes in den Zwischenraum zwischen den Platten einströmen zu lassen und die beiden Platten dann vollends miteinander zu verkleben, indem die Biegung der einen Platte rückgängig gemacht wird.

Es ist aber auch möglich, nach dem erstmaligen Abpumpen von Luft aus dem Zwischenraum zwischen den Platten das von Luft verschiedene Gas einströmen zu lassen, bis ein Druck, wie er in der umgebenden Atmosphäre herrscht, oder auch ein darüber hinaus gehender Druck erreicht ist, und danach einen Teil der nun im Zwischenraum zwischen den Platten des Solarmoduls enthaltenen Gasmischung wieder abzupumpen, bis der gewünschte Unterdruck erreicht ist. Diese Vorgehensweise ist vorteilhaft, wenn ein weitgehendes Abpumpen der Luft aus dem Zwischenraum zwischen den Platten zu aufwendig oder nicht ohne die Gefahr einer Beschädigung der Solarzellen möglich wäre. Die Zwischenräume, die in dem Solarzellenmodul zwischen den einzelnen Solarzellen und den sie einschließenden Platten vorhanden sind, haben einen nur geringen Querschnitt und eine geringe Höhe, die einen Gasaustausch behindern. Da jedoch der Zwischenraum zwischen den Platten des Moduls nicht lediglich gespült, sondern evakuiert wird, wird die Luft bzw. ein Luft-Gas-Gemisch auch aus den entlegensten Winkeln des Moduls abgezogen und hat das von Luft verschiedene Gas, welches man nach dem Evakuieren als Ersatz für die Luft in den Modul einströmen läßt, Gelegenheit, bis in dessen hinterste Winkel vorzudringen, so dass unter Anwendung des erfindungsgemäßen Verfahrens trotz der geringen Strömungsquerschnitte, die in dem Modul vorhanden sind, der erwünschte Gasaustausch innerhalb einer wirtschaftlichen Verfahrensdauer erzielbar ist. In einem fertig zusammengebauten Solarzellenmodul beträgt die Höhe der Zwischenräume (zwischen den Solarzellen), als Abstand der beiden Platten zwischen zwei benachbarten Solarzellen gemessen, größenordnungsmäßig nur 0,1 mm, bei einem im Schritt (e) nur teilweise zusammengebauten Solarzellenmodul beträgt der Abstand der Platten größenordnungsmäßig nur etwa 0,3 mm.

Eine vorteilhafte Weiterbildung der Erfindung besteht darin, dass die Schritte des Evakuierens von Gas aus dem Zwischenraum zwischen den Platten des Solarzellenmoduls und das anschließende Einströmenlassen des von Luft verschiedenen Gases wiederholt durchgeführt werden, um auch bei einer nur mäßigen, die empfindlichen Solarzellen keinesfalls schädigenden Druckabsenkung durch fortschreitende Verdünnung der Luft im Zwischenraum zwischen den Platten die erwünschte Konzentration des von Luft verschiedenen Gases zu erreichen, welche durch Einsatz eines Gassensors, insbesondere eines auf Sauerstoff ansprechenden Sensors, überwacht werden kann. Auf diese Weise läßt sich auch bei einer nur mäßigen Druckabsenkung auf zum Beispiel 600 Millibar schon durch vier Zyklen des Evakuierens des Luft-Gas-Gemisches und Einströmenlassens des von Luft verschiedenen Gases der Sauerstoffgehalt auf 3 % reduzieren. Bei den geringen Gasvolumina, die dazu bewegt werden müssen, erfordert das nur wenig Zeit und nur einen mäßigen apparativen Aufwand.

Der Druck, der letztlich zwischen den Platten des Solarzellenmoduls eingestellt wird, bevor dieser geschlossen wird, beträgt vorzugsweise 700 Millibar bis 800 Millibar. Als von Luft verschiedenes Gas wird ein Inertgas bevorzugt, insbesondere ein Edelgas wie zum Beispiel Argon.

Damit der Zwischenraum zwischen den Platten des Solarzellenmoduls evakuiert werden kann, muß er dicht abgeschlossen an eine Unterdruckquelle, zum Beispiel an eine Pumpe angeschlossen werden. Zu diesem Zweck kann der Zwischenraum zwischen den Tafeln des Solarzellenmoduls, welcher im Schritt (e) schon weitgehend abgeschlossen wurde, unmittelbar dicht abgeschlossen werden. Es ist aber auch möglich, einen etwas größeren Raum, welcher den Zwischenraum zwischen den Platten des Solarzellenmoduls mit umfaßt, dicht abzuschließen, zum Beispiel dadurch, dass man eine Kammer bildet, deren Innenraum nicht viel größer ist als der Solarzellenmodul im Schritt (e) und diese Kammer dicht abschließt oder indem man den nach Schritt (e) noch offenen Randbereich unter Einschluß eines Teils der Außenseite der beiden Platten des Solarzellenmoduls zum Beispiel mittels einer Kappe umschließt, welche man in der Umgebung des noch offenen Randbereiches des Solarzellenmoduls an diesen dicht anlegt. Bevorzugt wird eine Vorgehensweise, bei welcher eine Dichteinrichtung unmittelbar an den Rand der beiden Platten des Solarzellenmoduls angelegt wird, so dass sie den noch offenen Randbereich abdeckt. In diesem Fall ist das eingeschlossene Luft- bzw. Gasvolumen am kleinsten.

Den Gasaustausch nimmt man am einfachsten durch die Dichteinrichtung hindurch vor. Zu diesem Zweck kann man einen oder mehrere absperrbare Kanäle durch die Dichteinrichtung hindurchführen. Zum Beispiel kann man einen ersten Kanal benutzen, um Luft oder ein Luft-Gas-Gemisch aus dem abgeschlossenen Raum abzupumpen, und kann einen anderen Kanal benutzen, um das von Luft verschiedene Gas einzuleiten. Man kann aber auch beides durch denselben Kanal hindurch vornehmen, wenn man diesem mit einem Umschaltventil versieht.

Sieht man eine abschließbare Kammer vor, dann kann man auch so vorgehen, dass man in dieser Kammer zunächst einen Gasaustausch vornimmt, so dass sie das von Luft verschiedene Gas enthält, und dann die Schritte (d) bis (h), vorzugsweise auch den Schritt (c), in der von Luft verschiedenen Atmosphäre der Kammer durchführen.

Vorzugsweise werden die Schritte (d) bis (h) in einer Presse durchgeführt, welche zwei einander gegenüberliegende Pressplatten hat, deren Abstand voneinander veränderlich ist, wobei wenigstens einer der beiden Pressplatten eine Saugeinrichtung zugeordnet ist, mit welcher eine der beiden Platten des Solarzellenmoduls von der anderen Platte weggebogen und in gebogenem Zustand an der Pressplatte gehalten werden kann. Diese Vorgehensweise ist deshalb vorteilhaft, weil der Solarzellenmodul ohnehin durch Pressen verklebt werden muß, wenn man eine innerhalb enger Toleranzen gleichbleibende Dicke der Solarzellenmodule erreichen will. In diesem Fall können die beiden Pressplatten herangezogen werden, um eine die Solarzellenmodule dicht umschließende Kammer zu bilden oder um einen Beitrag zur Abdichtung des Zwischenraums zwischen den beiden Platten des Solarzellenmoduls zu liefern. Für die zuletzt genannte Verfahrensweise ist es besonders günstig, wenn beim Herstellen von Solarzellenmodulen mit rechteckigem Umriss eine Presse mit Pressplatten verwendet wird, welche ebenfalls einen rechteckigen Umriss haben, und wenn in einer solchen Presse der noch nicht verklebte Randbereich des Solarzellenmoduls in der Nähe des Randes der Pressplatten oder unmittelbar am Rand der Pressplatten angeordnet und die Dichteinrichtung an den Rand der Pressplatten und/oder an den Rand der beiden Platten des Solarzellenmoduls so angelegt wird, dass sie den noch nicht verklebten Randbereich der Platten abdeckt. Liegen die Pressplatten den Platten des Solarzellenmoduls dicht an, was zum Beispiel dadurch gewährleistet werden kann, dass die Pressplatten mit einer elastomeren Beschichtung versehen sind, welche so dünn ist, dass sie das Pressen des Solarzellenmoduls auf eine vorgegebene Dicke nicht beeinträchtigt, dann kann die Dichteinrichtung ohne Nachteil und ohne nennenswerte Vergrößerung des eingeschlossenen Gasvolumens anstatt an den Rand der Platten des Solarzellenmoduls auch an die Pressplatten angelegt werden oder zusätzlich zur Anlage am Rand der Platten des Solarzellenmoduls auch am Rand der Pressplatten angelegt werden, wodurch die Dichtwirkung erhöht wird.

Besonders bevorzugt ist eine Ausführungsform des erfindungsgemäßen Verfahrens, bei welcher der noch nicht verklebte Randabschnitt so gelegt wird, dass er sich über ein Ecke der beiden Platten des Solarzellenmoduls hinweg erstreckt. In diesen Fall kann bei einer der beiden Platten an der betreffenden Ecke ein Zipfel der Platte abgebogen werden. Das ist einfacher, als einen geradlinigen Randabschnitt abzubiegen. Außerdem wird dadurch eine Ausführungsweise des Verfahrens begünstigt, bei welcher das Luft-Gas-Gemisch in einer Richtung abgepumpt wird, welche von der Richtung, in welcher das von Luft verschiedene Gas eingeleitet wird, verschieden ist, insbesondere in zueinander rechtwinkligen Richtungen. Das begünstigt den Gasaustausch im Zwischenraum zwischen den Platten des Solarzellenmoduls.

In dem Solarzellenmodul besteht wenigstens eine der beiden Platten bevorzugt aus Glas, nämlich jene, welche der Sonne zugewandt werden soll. Die Rückseite des Moduls kann lichtundurchlässig sein und zum Beispiel aus Stahlblech oder aus Aluminium bestehen. Zwischen der rückseitigen Platte und den Solarzellen verlaufen die Leiterbahnen, welche die Solarzellen untereinander verbinden. Bestehen die Platten aus Glas, sind sie vorzugsweise 1 mm bis 4 mm dick. Bestehen die Platten aus Metall, können sie dünner sein, zum Beispiel 1 mm bis 2 mm. Zum Abbiegen eignen sich sowohl Platten aus Metall als auch Platten aus Glas. Das Abbiegen geschieht vorzugsweise dadurch, dass man mit einer Saugeinrichtung auf die betreffende Platte einwirkt und den abzubiegenden Bereich durch Verlagern des Saugers verlagert, wobei gleichzeitig der restliche Bereich der Platte, der eben bleiben soll, in seiner Lage parallel zu der anderen Platte zurückgehalten wird. Das kann zum Beispiel dadurch geschehen, dass der Bereich der Platte, der eben bleiben soll an einer massiven ebenen Platte fixiert wird. Eine solche Fixierung kann dadurch geschehen, dass die Platte des Solarzellenmoduls an der massiven Platte angesaugt wird. Zu diesem Zweck kann die massive Platte mit über ihre Fläche verteilten Bohrungen versehen sein, welche mit der Saugseite eines Gebläses verbunden sind.

Zum Verkleben der Platten des Solarzellenmoduls miteinander wird vorzugsweise eine thermoplastische Klebe- und Dichtmasse verwendet, insbesondere eine solche auf der Basis eines Polyisobutylens, das ist ein künstlicher Buthylkautschuk, welcher in dem für solche Solarzellenmodule typischen Temperaturbereich von -40 °C bis +80°C gute Klebeeigenschaften, gute Dichtwirkung und gute Lichtbeständigkeit miteinander verbindet.

Die beigefügten Zeichnungen zeigen zwei Ausführungsbeispiele von Vorrichtungen zur Verwendung in dem erfindungsgemäßen Verfahren. Gleiche bzw. einander entsprechende Teile sind in den Beispielen mit übereinstimmenden Bezugszahlen bezeichnet.
- Figur 1: zeigt eine Außenansicht einer Presse zur Verwendung in dem erfindungsgemäßen Verfahren,
- Figur 2: zeigt als Detail einen Ausschnitt aus der Presse mit Blick auf die Innenseite einer der beiden Pressplatten und mit einem in der Presse angeordneten, noch nicht vollständig geschlossenen Solarzellenmodul, welchem eine Dichteinrichtung anliegt,
- Figur 3: zeigt den Schnitt A-A aus Figur 2,
- Figur 4: zeigt den Schnitt B-B aus Figur 2,
- Figur 5: zeigt in einer Ansicht entsprechend der Figur 2 einen Ausschnitt aus einer Presse, mit einer abgewandelten Dichteinrichtung und
- Figur 6: zeigt als Detail die Dichteinrichtung aus Figur 5 in einer unwirksamen Stellung.

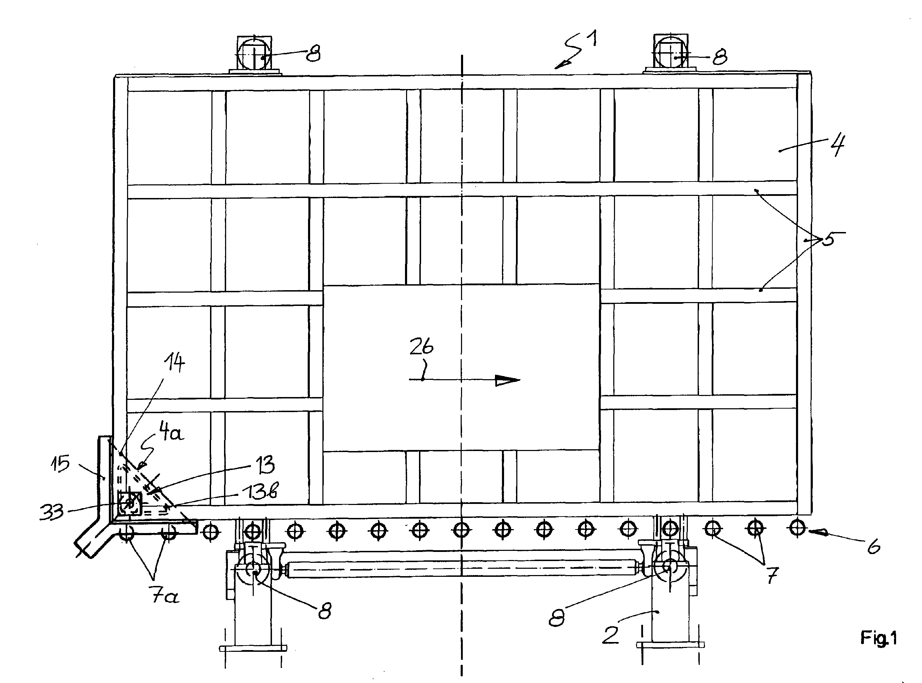

Die Figuren 1 bis 4 zeigen eine Presse 1, welche auf einem Gestell 2 zwei Pressplatten 3 und 4 hat, deren einander zugewandte Vorderseiten eben ausgebildet sind, während ihre Rückseiten durch ein Fachwerk 5 versteift sind.

Unterhalb des unteren Randes der Pressplatten 3 und 4 ist ein Waagerechtförderer 6 angeordnet, welcher eine Zeile von synchron antreibbaren Rollen 7 aufweist, deren Achsen senkrecht zur Vorderseite der Pressplatten 3 und 4 verlaufen. Die Pressplatten 3 und 4 sind parallel zueinander angeordnet und durch vier synchron antreibbare Anordnungen 8 aus je einer Spindel und einer Spindelmutter miteinander verbunden. Durch Antreiben der Spindeln oder Spindelmuttern kann die eine Pressplatte 4 gegenüber der anderen Pressplatte 3 parallel zu sich selbst verschoben werden.

Die Pressplatten 3, 4 sind um einen spitzen Winkel von zum Beispiel 6 ° gegen die Senkrechte geneigt angeordnet, so dass eine auf den Rollen 7 stehende Platte 9 oder 10 gegen die eine Pressplatte 3 gelehnt werden kann, wobei sie dieser flächig anliegt.

Beide Pressplatten 3 und 4 weisen Bohrungen 11 auf, die über die Pressplatten 3, 4 verteilt angeordnet sind und durch welche mittels eines nicht dargestellten Gebläses, welches der Presse 1 zugeordnet ist, wahlweise Luft geblasen oder gesaugt werden kann.

In der Presse 1 kann ein Solarzellenmodul 12 zusammengebaut werden. Dazu wird die Presse 1 zweckmäßigerweise in eine Fertigungslinie eingebaut, welche eine oder mehrere der Presse 1 vorangestellte Stationen und eine oder mehrere der Presse 1 nachgeordnete Stationen hat, die ebenfalls einen Waagerechtförderer aufweisen, auf welchen Solarzellenmodule, bzw. deren Platten in der selben Höhenlage und mit derselben Neigung wie in der Presse 1 gefördert werden können.

Die bewegliche Pressplatte 4 ist an ihrer einen unteren Ecke mit einer Saugeinrichtung 13 versehen, deren Saugseite in der Flucht der ebenen Vorderseite der Pressplatte 4 angeordnet und gegen die gegenüberliegende Pressplatte 3 gerichtet ist. Die Saugeinrichtung 13 weist in der Vorderseite der Pressplatte 4 eine flache Mulde 13a mit dreieckig verlaufendem Rand auf, welche von einer entsprechend dreieckig verlaufenden Dichtung 13b umgeben ist, die in einer Nut in der Pressplatte 4 angeordnet ist und in unbelastetem Zustand über deren Vorderseite vorsteht. In die Mulde 13a mündet eine Bohrung 13c, welche an ein nicht dargestelltes Saugaggregat angeschlossen ist. Die Saugeinrichtung 13 ist in einen dreieckigen Abschnitt 4a der Pressplatte 4 integriert, welcher um eine Linie 14, welche nachfolgend auch als Biegelinie bezeichnet wird und den waagerechten sowie den senkrechten Rand der Pressplatte 4 unter einem Winkel von 45 ° schneidet, verschwenkbar gelagert. Dieser dreieckige Abschnitt 4a mit der integrierten Saugeinrichtung 13 kann mittels eines Betätigungsorgans, zum Beispiel mittels eines gelenkig an der Rückseite der Pressplatte 4 angebrachten Druckmittelzylinders 33, aus einer ersten Stellung, in welcher die Vorderseite der Saugeinrichtung 13 mit der restlichen Vorderseite der Pressplatte 4 fluchtet, und einer zweiten Stellung verschwenkt werden, in welcher der dreieckige Abschnitt 4a mit der integrierten Saugeinrichtung 13 um die Biegelinie 14 ein Stück weit nach hinten, d. h. von der gegenüberliegenden Pressplatte 3 weggeschwenkt ist.

Dem Abschnitt 4a der Pressplatte, an welchem die Saugeinrichtung 13 angeordnet ist, ist eine Dichteinrichtung 15 zugeordnet, welche zwei rechtwinklig zueinander stehende Schenkel 16 und 17 hat. Auf der Seite der Schenkel 16, 17, welche den Pressplatten 3 und 4 zugewandt sind, ist eine rahmenförmige Dichtung 18 angeordnet, welche an den freien Enden der Schenkel 16, 17 jeweils einen Abschnitt 19 hat, welcher senkrecht zur Vorderseite der Pressplatten 3 und 4 verläuft. Diese beiden Abschnitte 19 der Dichtung 18 sind durch zwei Abschnitte 20 miteinander verbunden, welche sich längs der Schenkel 16 und 17 erstrecken. Die Dichtung 18 hat mithin die Gestalt eines schmalen Rechtecks, welches in der Mitte rechtwinklig gefaltet ist.

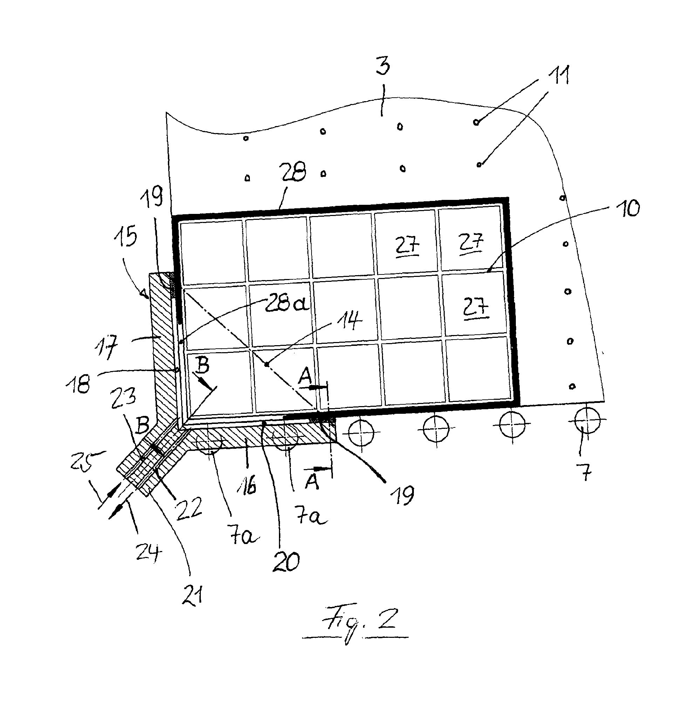

Vom Scheitel der beiden Schenkel 16 und 17 geht ein Stutzen 21 aus, welcher sich zum Beispiel unter einem Winkel von 135 ° zu den Schenkeln 16 und 17 erstreckt. Dieser Stutzen 21 enthält zwei Kanäle 22 und 23, welche sich vom äußeren Ende des Stutzens 21 durchgehend bis zur Innenseite der Schenkel 16 und 17 erstrecken. An den Kanal 22 ist ein Saugaggregat angeschlossen, in Figur 2 symbolisch durch einen Pfeil 24 dargestellt. An den Kanal 23 ist eine Quelle für ein von Luft verschiedenes Gas angeschlossen, in Figur 2 symbolisch dargestellt durch einen Pfeil 25. Das von Luft verschiedene Gas kann in einem Druckbehälter gespeichert sein.

Mit Hilfe einer solchen Presse kann ein Solarzellenmodul 12 folgendermaßen zusammengebaut werden:

Eine erste Platte 9, welche vorzugsweise aus Glas besteht, wird von einer der Presse 1 vorangestellten Station einer Fertigungslinie in die Presse 1 gefördert, in welcher sie auf den Rollen 7 steht und gegen die nach hinten geneigte Pressplatte 3 gelehnt ist. Sie wird in die Presse 1 gefördert, bis ihr bezogen auf die Förderrichtung 26 hinterer aufragender Rand mit dem hinteren Rand der Pressplatte 3 bündig abschließt. An diesem Rand befindet sich auch die Saugeinrichtung 13. (Die Presse 1 kann aber auch mit entgegengesetzter Förderrichtung betrieben werden. In diesem Fall fördert man die Platte 9, bis sie mit ihrem vorderen Rand mit dem in Förderrichtung vorderen Rand bündig liegt, an welchem sich die Saugeinrichtung 13 befindet.) Mit Erreichen dieser Stellung wird der Waagerechtförderer 6 stillgesetzt, die bewegliche Pressplatte 4 gegen die erste Platte 9 vorgeschoben, die erste Platte 9 angesaugt und zusammen mit der beweglichen Pressplatte 4 von der feststehenden Pressplatte 3 wegbewegt. Nun wird eine zweite Platte 10, welche aus Glas oder aus einem Metall bestehen kann, auf dem Waagerechtförderer 6 in die Presse 1 gefördert, bis auch ihr hinterer Rand mit dem hinteren Rand der Pressplatten 3 und 4 bündig liegt. Diese zweite Platte 10 trägt eine Anzahl von Solarzellen 27 in regelmäßiger Anordnung, wie in Figur 2 dargestellt.

Die Solarzellen wurden zuvor in einer der Presse 1 vorangestellten Station der Fertigungslinie auf die Platte 10 aufgetragen. Das geschieht zum Beispiel dadurch, dass die Platte 10 zunächst stellenweise mit einem Klebstoff beschichtet wird, an welchen nachfolgend die Solarzellen 27 gedrückt werden, wobei Leiterbahnen, welche mit den Solarzellen 27 verbunden sind, in den Klebstoff gedrückt werden können. Außerdem wird in einer der Presse 1 vorangestellten Station der Fertigungslinie auf die Platte 10 ein Strang 28 aus einer thermoplastischen Klebe- und Dichtmasse aufgetragen. Dieser Strang 28 wird auf dieselbe Seite der Platte 10 aufgetragen, auf welcher sich die Solarzellen 27 befinden, und zwar unmittelbar am Rand der Platte 10, so, dass der Strang 28 lückenlos um die ganze Platte 10 herumführt.

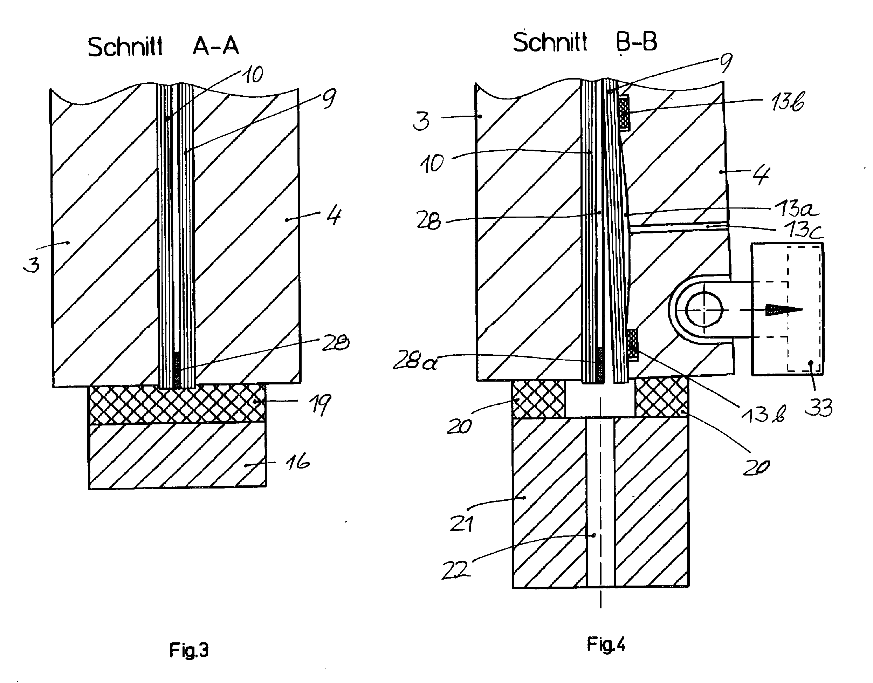

In dem Abschnitt 4a der Pressplatte 4 werden die Saugeinrichtung 13 und das Betätigungsorgan 33 zum Abbiegen des die Saugeinrichtung 13 tragenden, durch die Biegelinie 14 begrenzten Abschnittes 4a der Pressplatte 4 aktiviert. Dadurch wird die Platte 9 im Bereich ihrer unteren Ecke von der Saugeinrichtung 13 angesaugt und von der gegenüberliegenden Pressplatte 3 weggebogen. Ist das geschehen und liegen die beiden Platten 9 und 10 einander deckungsgleich gegenüber, wird die Pressplatte 4 der Pressplatte 3 angenähert, bis die erste Platte 9 in ihrem nicht abgebogenem Bereich auf den Strang 28 aus Klebe- und Dichtmasse trifft, welcher sich auf der Platte 10 befindet, und mit ihm verklebt. Die Länge, auf welcher die beiden Platten 9 und 10 nun miteinander verklebt sind, ist in Figur 2 geschwärzt dargestellt. In dem noch nicht verklebten Abschnitt 28a ist der Strang 28 durch einen Doppelstrich dargestellt. In diesen noch nicht verklebten Abschnitt 28 ist der teilweise zusammengebaute Solarzellenmodul 12 noch offen.
An den noch offenen Randabschnitt des Solarzellenmoduls 12 wird nun die Dichteinrichtung 15 angelegt, indem diese aus der Richtung von der beweglichen Pressplatte 4 herkommend in Richtung gegen die feststehende Pressplatte 3 bewegt wird. Rollen 7a des Waagerechtförderers 6, auf welche sie trifft und welche sich im Bereich der Saugeinrichtung 13 befinden, sind so gelagert, dass sie gegen Federkraft zurückweichen können, so dass der untere Schenkel 16 der Dichteinrichtung 15 diese Rollen 7a wegschiebt und ihren Platz einnimmt. Ist das geschehen, wird die Dichteinrichtung 15 in diagonaler Richtung an den Rand der Pressplatten 3 und 4 und ebenso an den Rand der Platten 9 und 10 des Solarzellenmoduls 12 angedrückt, wodurch der gesamte offene Bereich am Rand des Solarzellenmoduls 12 dicht umschlossen wird, wie in den Figuren 3 und 4 dargestellt.

Nun wird, während der Kanal 23 abgesperrt ist, durch den Kanal 22 Luft aus dem Zwischenraum zwischen den beiden Platten 9 und 10 abgepumpt, bis in dem Zwischenraum zwischen den Platten 9 und 10 ein vorgegebener Unterdruck erreicht ist. Dann wird der Kanal 22 abgesperrt und statt dessen der Kanal 23 geöffnet und über den Kanal 23 ein von Luft verschiedenes Gas in den Zwischenraum zwischen den Platten 9 und 10 geleitet, welches die abgepumpte Luft ersetzt. Diese Vorgänge werden so oft wiederholt, bis ein Sauerstoffsensor, welcher den Sauerstoffgehalt des durch den Kanal 22 abgepumpten Gases überwacht, anzeigt, dass der Sauerstoffgehalt einen vorgegebenen Grenzwert unterschreitet. Ist das erreicht, wird in dem Zwischenraum zwischen den Platten 9 und 10 ein vorgegebener Unterdruck eingestellt, vorzugsweise ein Druck zwischen 800 Millibar und 700 Millibar absolut. Ist das geschehen, wird das Betätigungsorgan 33 für den Abschnitt 4a der Pressplatte 4 betätigt, um diesen aus seiner hinteren Lage, in welcher er die gebogene Platte 9 gehalten hat, in seine vordere Lage zurückzuführen, in welcher die Biegung der Platte 9 vollständig rückgängig gemacht ist. Dadurch wird der bisher nicht verklebte Randabschnitt des Solarzellenmoduls 12 hermetisch verschlossen.

Die Saugeinrichtung 13 wird nun deaktiviert und die Pressplatte 4 der Presse wird betätigt, um den Solarzellenmodul auf eine vorgegebene Dicke zu verpressen. Danach wird das Ansaugen von Luft durch die Bohrungen 11 der beweglichen Pressplatte 4 unterbrochen, so dass diese sich von dem Solarzellenmodul 12 lösen kann. Die Presse wird durch Parallelverschiebung der beweglichen Pressplatte 4 geöffnet und der zusammengebaute Solarzellenmodul 12 in der Förderrichtung 26 aus der Presse 1 in eine ihr nachgeordnete Station der Fertigungslinie gefördert. Während dieses Fördervorganges, ebenso wie beim Hereinfördern der Platten 9 und 10 in die Presse tritt aus den Bohrungen 11 der Pressplatte 3 Luft aus, welche zwischen der Pressplatte 3 und den Platten 9 bzw. 10 ein Luftkissen erzeugt, auf welchem diese bzw. der Solarzellenmodul 12 reibungsarm und sicher gleiten können.

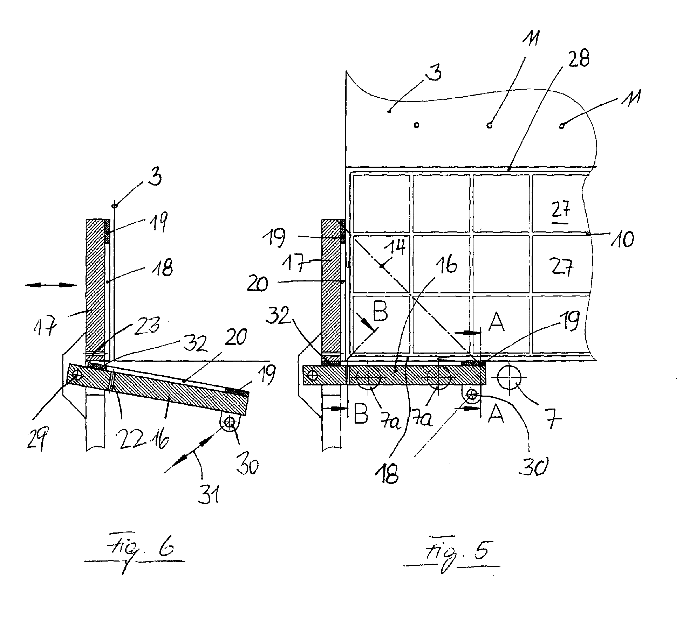

Das in den Figuren 5 und 6 dargestellte Ausführungsbeispiel unterscheidet sich von dem in den Figuren 1 bis 4 dargestellten Ausführungsbeispiel darin, dass die Dichteinrichtung 15 einen anderen Aufbau hat. Zwar besteht sie auch in diesem Beispiel aus zwei Schenkeln 16 und 17, doch sind diese nicht zu einem starren Gebilde zusammengefügt. Vielmehr ist der in seiner Wirkstellung waagerechte, untere Schenkel 16 gegenüber dem senkrechten Schenkel 17 um eine Achse 29 verschwenkbar. Um den unteren Schenkel 16 verschwenken zu können, greift an einem Gelenkpunkt 30 des Schenkels 16 ein Druckmittelzylinder an, welcher in Figur 6 symbolisch durch einen Pfeil 31 dargestellt ist. Infolge der Verschwenkbarkeit der beiden Schenkel 16 und 17 gegeneinander geht die Dichtung 18 nicht ohne Unterbrechung vom Schenkel 16 auf den Schenkel 17 über, vielmehr ist an der Stoßstelle zwischen den beiden Schenkeln 16 und 17 in der Nähe der Achse 29 noch eine ergänzende Dichtung 32 vorgesehen.

Beim Anlegen der Dichteinrichtung 15 an den Rand der Pressplatten 3 und 4 und an den Rand der Platten 9 und 10 wird zunächst der senkrechte Schenkel 17 angelegt. Dann werden die am Abschnitt 4a liegenden Rollen 7a des Waagerechtförderers 6 zurückgezogen, um Platz zu machen für den unteren Schenkel 16 der Dichteinrichtung 15, der daraufhin gegen den unteren Rand der Pressplatten 3 und 4 und der Platten 9 und 10 geschwenkt wird. Der Kanal 22 für das Absaugen von Luft befindet sich in diesem Fall in dem unteren Schenkel 16 und verläuft in senkrechter Richtung. Der Kanal 23 für das Zuführen eines von Luft verschiedenen Gases befindet sich hingegen in dem Schenkel 17 und verläuft in waagerechter Richtung. Eine derartige Anordnung begünstigt den Gasaustausch im Raum zwischen den Platten und 10.

### Bezugszahlenliste:

- 1.: Presse
- 2.: Gestell
- 3.: Pressplatte
- 4.: Pressplatte
- 4a.: Abschnitt von 4
- 5.: Fachwerk
- 6.: Waagerechtförderer
- 7.: Rollen
- 7a.: Rollen
- 8.: Spindel/Spindelmutter
- 9.: 1. Platte
- 10.: 2. Platte
- 11.: Bohrungen
- 12.: Solarzellenmodul
- 13.: Saugeinrichtung
- 13a.: Mulde
- 13b.: Dichtung
- 13c.: Bohrung
- 14.: Linie, (Biegelinie)
- 15.: Dichteinrichtung
- 16.: Schenkel von 15
- 17.: Schenkel von 15
- 18.: Dichtung
- 19.: Abschnitt von 18 senkrecht zur Pressplatte
- 20.: Abschnitt von 18 längs der Schenkel 16, 17
- 21.: Stützen von 15
- 22.: Kanal in 21
- 23.: Kanal in 21
- 24.: Saugaggregat, Pfeil
- 25.: Quelle für ein von Luft verschiedenes Gas, Pfeil
- 26.: Förderrichtung
- 27.: Solarzellen
- 28.: Strang aus Klebe- und Dichtmasse
- 28a.: Abschnitt von 28
- 29.: Achse
- 30.: Gelenkpunkt
- 31.: Pfeil (Druckmittelzylinder)
- 32.: ergänzende Dichtung
- 33.: Druckmittelzylinder

## Patentansprüche

1. Verfahren zum Zusammenbauen eines Solarzellenmoduls (12), bestehend aus zwei zueinander parallelen, an ihrem Rand dicht miteinander verklebten Platten (9, 10), von denen wenigstens eine lichtdurchlässig ist, zwischen welchen mehrere Solarzellen (27) angeordnet sind und sich ein von Luft verschiedenes Gas befindet, **gekennzeichnet durch** folgende Verfahrensschritte
(a) Auftragen einer Klebe- und Dichtmasse auf den Rand von wenigstens einer der beiden Platten (9, 10),
(b) Anbringen der Solarzellen (27) an wenigstens einer der Platten (9, 10),
(c) Wegbiegen wenigstens eines Abschnittes einer (9) der beiden Platten von der gegenüberliegenden Platte (10), wobei der Abschnitt, der weggebogen wird, einen Randbereich der Platte (9) einschließt,
(d) Anordnen der beiden Platten (9, 10) einander gegenüberliegend,
(e) Annähern der beiden Platten (9, 10) aneinander, so dass sie mit Ausnahme des weggebogenen Randbereiches miteinander verkleben,
(f) Abdichten eines den Zwischenraum zwischen den Platten (9, 10) einschließenden Raumes am Randbereich des Solarzellenmoduls (12) oder in der Umgebung des noch offenen Randbereiches des Solarzellenmoduls (12),
(g) Abpumpen von Gas aus dem Raum unter Absenkung des Drucks in dem Raum,
(h) Rückgängigmachen der Biegung der einen Platte (9) und Verkleben der beiden Platten (9, 10) miteinander auch in dem Randbereich, in welchem sie bisher noch nicht miteinander verklebt waren, unter Aufrechterhaltung eines Unterdrucks in dem Raum.

2. Verfahren nach Anspruch 1, **dadurch gekennzeichnet, dass** vor dem Schritt (h) Luft in dem Raum durch ein von Luft verschiedenes Gas ersetzt wird.

3. Verfahren nach Anspruch 2, **dadurch gekennzeichnet, dass** das von Luft verschiedene Gas ein Inertgas ist, insbesondere ein Edelgas.

4. Verfahren nach einem der vorstehenden Ansprüche, **dadurch gekennzeichnet, dass** mit dem Schritt (g) in dem Raum ein Druck von 800 Millibar bis 700 Millibar (absolut) eingestellt wird.

5. Verfahren nach einem der vorstehenden Ansprüche, **dadurch gekennzeichnet, dass** das von Luft verschiedene Gas zwischen den Schritten (g) und (h) in den Raum eingeleitet wird.

6. Verfahren nach Anspruch 5, **dadurch gekennzeichnet, dass** das von Luft verschiedene Gas durch eine zum Abdichten des Raumes verwendete Einrichtung (15) hindurch zugeführt und Luft bzw. ein Luft enthaltendes Gasgemisch durch eine solche Einrichtung (15) aus dem Raum entfernt wird.

7. Verfahren nach Anspruch 5 oder 6, **dadurch gekennzeichnet, dass** das von Luft verschiedene Gas in den Raum unter Erhöhung des Drucks in dem Raum eingeleitet wird und dass danach ein Teil des in dem Raum vorhandenen Gasgemisches unter Absenkung des Druckes in dem Raum abgepumpt wird.

8. Verfahren nach Anspruch 7, **dadurch gekennzeichnet, dass** beim Einleiten des von Luft verschiedenen Gases der Druck in dem Raum auf den Druck der umgebenen Atmosphäre erhöht wird.

9. Verfahren nach Anspruch 7, **dadurch gekennzeichnet, dass** die Schritte des Einleitens des von Luft verschiedenen Gases und des daraufhin erfolgenden Abpumpens des Gasgemisches aus dem Raum gemäß Anspruch 7 wiederholt durchgeführt werden.

10. Verfahren nach einem der vorstehenden Ansprüche, **dadurch gekennzeichnet, dass** spätestens vor dem Schritt (g), vorzugsweise zwischen den Schritten (c) und (d), der Zwischenraum zwischen den Platten (9, 10) mit dem von Luft verschiedenen Gas gespült wird.

11. Verfahren nach einem der Ansprüche 1 bis 4, **dadurch gekennzeichnet, dass** die Schritte (d) bis (h) in einer von Luft verschiedenen Atmosphäre durchgeführt werden.

12. Verfahren nach Anspruch 11, **dadurch gekennzeichnet, dass** auch der Schritt (c) in der von Luft verschiedenen Atmosphäre durchgeführt wird.

13. Verfahren nach einem der vorstehenden Ansprüche, **dadurch gekennzeichnet, dass** die Schritte (d) bis (h) in einer Presse (1) durchgeführt werden, welche zwei einander gegenüberliegende Pressplatten (3, 4) hat, deren Abstand voneinander veränderlich ist, wobei wenigstens einer der beiden Pressplatten (4) eine Saugeinrichtung (13) zugeordnet ist, mit welcher eine der beiden Platten (9) von der anderen Platte (10) weggebogen und in gebogenem Zustand an der Pressplatte (4) gehalten wird.

14. Verfahren nach einem der vorstehenden Ansprüche, **dadurch gekennzeichnet, dass** eine Dichteinrichtung (15) an den Rand der beiden Platten (9,10), den noch nicht verklebten Randabschnitt abdeckend, angelegt wird.

15. Verfahren nach Anspruch 13 oder 14 zum Herstellen von Solarzellenmodulen mit rechteckigem Umriss unter Verwendung einer Presse (1) mit Pressplatten (3, 4), welche einen rechteckigen Umriss haben, **dadurch gekennzeichnet, dass** der noch nicht verklebte Randbereich des Solarzellenmoduls (12) in der Nähe des Randes der Pressplatten (3, 4) angeordnet und die Dichteinrichtung (15) an den Rand der Pressplatten (3, 4) und/oder an den Rand der beiden Platten (9, 10), den noch nicht verklebten Randbereich der Platten (9, 10) abdeckend, angelegt wird.

16. Verfahren nach einem der vorstehenden Ansprüche, **dadurch gekennzeichnet, dass** sich der noch nicht verklebte Randabschnitt der beiden Platten (9, 10) über eine Ecke der beiden Platten (9, 10) hinweg erstreckt.

17. Verfahren nach einem der vorstehenden Ansprüche, **dadurch gekennzeichnet, dass** wenigstens eine der beiden Platten (9,10) aus Glas besteht.

18. Verfahren nach Anspruch 17, **dadurch gekennzeichnet, dass** die hintere der beiden Platten (9,10) aus Metall, insbesondere aus Aluminium oder aus einem Stahlblech besteht.

19. Verfahren nach Anspruch 15 oder 16, **dadurch gekennzeichnet, dass** wenigstens eine der beiden Platten (9, 10) aus Glas besteht und 1 mm bis 4 mm dick ist.

20. Verfahren nach einem der vorstehenden Ansprüche, **dadurch gekennzeichnet, dass** eine thermoplastische Klebe- und Dichtmasse verwendet wird, insbesondere eine solche auf der Basis eines Polyisobutylens.

21. Vorrichtung zum Zusammenbauen und Verkleben eines Solarzellenmoduls zur Verwendung in einem Verfahren nach einem der vorstehenden Ansprüche, **gekennzeichnet durch** zwei Pressplatten (3, 4), denen ein Waagerechtförderer (6) zugeordnet ist, um Platten (9, 10) für ein Solarzellenmodul (12) in den Zwischenraum zwischen den Pressplatten (3, 4) zu fördern und ein daraus gebildetes Solarzellenmodul (12) aus dem Zwischenraum zwischen den Pressplatten (3, 4) herauszufördern, wobei eine der beiden Pressplatten (4) Mittel zum Ansaugen (11, 13) einer Platte (9) und im Bereich (4a) einer Ecke dieser Pressplatte (4) Mittel (33) zum Biegen der angesaugten Platte (9) hat, und weiterhin **gekennzeichnet durch** eine Dichteinrichtung (15), welche im Bereich (4a) der Mittel zum Biegen an den Rand der Pressplatten (3, 4) und/oder an den Rand der Platten (9, 10) des Solarzellenmoduls (12) anlegbar ist, und Mittel (22, 23) zum Evakuieren des Zwischenraumes zwischen den Platten (9, 10) und Mittel zum nachfolgendem Einleiten eines von Luft verschiedenen Gases in den Zwischenraum **durch** die Dichteinrichtung (15) hindurch aufweist.
